# EUROPÄISCHE PATENTSCHRIFT

(11) **EP 1 287 617 B1**
(45) Veröffentlichungstag und Bekanntmachung des Hinweises auf die Patenterteilung: **03.12.2003**
(21) Anmeldenummer: 01931438.4
(22) Anmeldetag: 11.04.2001
(51) Int. Cl.: H03M 13/00, H03M 13/39, H03M 13/45, H03M 13/23, H04N 7/64

(54) **VERFAHREN ZUM KANALDECODIEREN EINES DATENSTROMS MIT NUTZDATEN UND REDUNDANZDATEN, VORRICHTUNG ZUM KANALDECODIEREN, COMPUTERLESBARES SPEICHERMEDIUM UND COMPUTERPROGRAMM-ELEMENT**
METHOD FOR CHANNEL DECODING A DATA STREAM CONTAINING USEFUL DATA AND REDUNDANT DATA, DEVICE FOR CHANNEL DECODING, COMPUTER-READABLE STORAGE MEDIUM AND COMPUTER PROGRAM ELEMENT
PROCEDE DE DECODAGE CANAL D'UN TRAIN DE DONNEES AVEC DONNEES UTILES ET DONNEES REDONDANTES, DECODEUR CANAL, SUPPORT MEMOIRE LISIBLE A L'ORDINATEUR ET ELEMENT DE PROGRAMME D'ORDINATEUR

(30) Priorität: 14.04.2000 DE 10018624
(43) Veröffentlichungstag der Anmeldung: 05.03.2003
(73) Patentinhaber: SIEMENS AKTIENGESELLSCHAFT, 80333 München (DE)
(72) Erfinder: BURKERT, Frank, 80796 München (DE); BÄSE, Gero, 81371 München (DE); BUSCHMANN, Ralf, 85635 Höhenkirchen-Siegertsbrunn (DE)
(86) Internationale Anmeldenummer: DE0101431
(87) Internationale Veröffentlichungsnummer: WO01080432

(56) Entgegenhaltungen:
- EP-A- 0 790 741
- EP-A- 0 980 148
- DE-A- 3 443 041
- US-A- 5 703 887
- LI FUNG CHANG ET AL: "PERFORMANCE OF A TDMA PORTABLE RADIO SYSTEM USING A CYCLIC BLOCK CODE FOR BURST SYNCHRONIZATION AND ERROR DETECTION" IEEE TRANSACTIONS ON COMMUNICATIONS, IEEE INC. NEW YORK, US, Bd. 41, Nr. 1, 1993, Seiten 22-31, XP000367750 ISSN: 0090-6778

## Beschreibung

Die Erfindung betrifft ein Verfahren zum Kanaldecodieren eines Datenstroms mit Nutzdaten und Redundanzdaten, Vorrichtungen zum Kanaldecodieren eines Datenstroms sowie ein computerlesbares Speichermedium und ein Computerprogramm-Element.

Ein solches Verfahren und solche Vorrichtungen sind aus [1] bekannt.

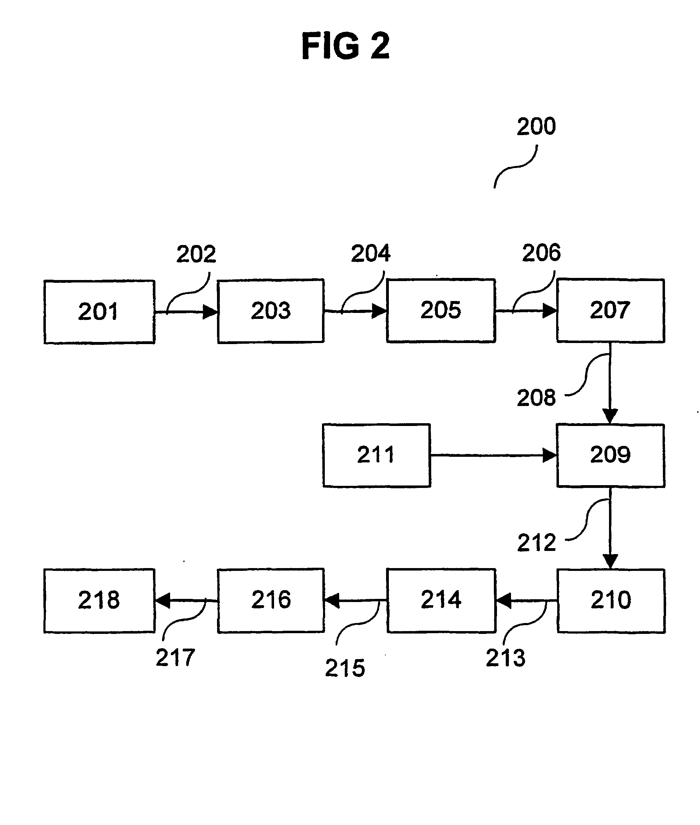

Diesem aus [1] bekannten Prinzip liegt das in **Fig.2** dargestellte Modell der digitalen Nachrichtenübertragung mit Kanalcodierung und Quellencodierung zugrunde.

In dem Modell 200 der digitalen Nachrichtenübertragung wird von einer Quelle 201 Quelleninformation 202 einem Quellencoder 203 zugeführt, in dem ein Datenstrom 204 erzeugt wird.

Der Datenstrom 204 wird einem Kanalcoder 205 zugeführt, von diesem kanalcodiert und der kanalcodierte Datenstrom 206 wird einem Modulator 207 zugeführt, wo der kanalcodierte Datenstrom 206 einem Trägersignal vorgebbarer Frequenz aufmoduliert wird und als moduliertes Signal 208 über einen physikalischen Kanal 209, beispielsweise über eine Funkverbindung oder auch über eine Telefonleitung, einem Empfänger, der einen Demodulator 210 aufweist, zugeführt.

In dem physikalischen Kanal 209 unterliegt das modulierte Signal 208 Störungen 211, wodurch ein gestörtes moduliertes Signal 212 erzeugt wird.

Ein demodulierter Datenstrom 213 wird einem Kanaldecoder 214 zugeführt, in dem eine Kanaldecodierung erfolgt, wodurch ein kanaldecodierter Datenstrom 215 erzeugt wird. In einem Quellendecoder 216 wird der kanaldecodierte Datenstrom 215 decodiert und als Ergebnisdatenstrom 217 einer Senke 218 zugeführt.

Unter einer Quellencodierung ist eine Codierung zu verstehen, in der die zu übertragenden Daten komprimiert werden, das heißt überflüssige Redundanz in den zu übertragenden Daten eliminiert wird.

Im Rahmen dieser Erfindung ist unter Kanalcodierung eine Methode bzw. ein Verfahren zu verstehen, mit dem ein Datenstrom durch Hinzufügen von Redundanzdaten codiert wird, so dass von der Quelle zu einer Senke der zu übertragende Datenstrom mit einer möglichst geringen Anzahl von Fehlern übertragen werden kann. Somit wird im Rahmen der Kanalcodierung den eigentlichen Nutzdaten sendeseitig kontrolliert Redundanz hinzufügt, so dass bei der Übertragung über den physikalischen Kanal 209 entstandene Fehler empfangsseitig erkannt und korrigiert werden können.

Ein Prinzip, dem einige Verfahren der Kanalcodierung zugrundeliegen, ist das Prinzip der Vorwärtsfehlerkorrektur, d.h., es werden bei diesem Prinzip empfangsseitig ermittelte Fehler unmittelbar korrigiert. Beispiele von Vorwärtsfehlerkorrekturverfahren sind Verfahren, die Blockcodes, Faltungscodes, gelochte Faltungscodes oder verkettete Codes verwenden. Anschaulich erfolgt bei Vorwärtsfehlerkorrekturverfahren die Kanaldecodierung allein aus dem empfangenen Datenstrom, d.h. ohne Wiederholungsanforderungen über einen Rückkanal.

Alternative Verfahren zur Kanalcodierung sind die als Automatic Repeat Request, kurz ARQ-Verfahren, bezeichnete Verfahren, die darauf basieren, dass Fehler empfangsseitig erkannt werden und mit Hilfe von Retransmissionen die Übertragungsfehler korrigiert werden.

Die Kombination aus Vorwärtsfehlerkorrekturverfahren und ARQ-Verfahren wird als hybrides ARQ Verfahren, in [2] beschrieben, bezeichnet. Bei einem solchen Verfahren wird sendeseitig die Nutzinformation zunächst mit einem fehlererkennenden Code codiert. Anschließend werden die Nutzdaten zusammen mit der hinzugefügten Redundanz mit einem fehlerkorrigierenden Code codiert. Empfangsseitig wird zunächst der fehlerkorrigierende Code decodiert (Vorwärtsfehlerkorrektur). Anschließend wird mit Hilfe des fehlererkennden Codes geprüft, ob im decodierten Datenstrom noch Restfehler vorhanden sind. Ist dies der Fall, wird eine Wiederholung der Daten über einen Rückkanal angefordert (Repeat Request). Der Vorteil von hybriden ARQ-Verfahren ist, dass man eine quasi-fehlerfreie Übertragung erreicht, dafür aber eine sehr große Verzögerung der Übertragung der vollständigen, fehlerfreien Daten in Kauf nehmen muss und die vorhandene Bandbreite durch die wiederholten Übertragungen nicht effizient ausgenutzt werden.

Nachteilig an den Verfahren zur Kanalcodierung und Kanaldecodierung ist, dass eine große Anzahl von Redundanzdaten den Nutzdaten hinzugefügt werden muss, wodurch die verfügbare Nutzdatenrate deutlich reduziert wird.

Insbesondere bei der Übertragung von Videodaten ist jedoch eine hohe Nutzdatenrate erforderlich.

Bei einem ARQ-Verfahren ist ein weiterer Nachteil darin zu sehen, dass zwar eine gesicherte Übertragung der Nutzdaten möglich ist, gleichzeitig aber durch eine wiederholte Übertragung von Nutzdaten durch den Sender eine erhebliche Verzögerung beim Empfang der vollständigen Daten beim Empfänger zu verzeichnen ist, wodurch ein solches Verfahren insbesondere für eine Echtzeitanwendung nicht geeignet ist.

Aus diesem Grunde kommen insbesondere bei der Übertragung von Videodaten üblicherweise nur relativ einfache Kanalcodierungsverfahren, basierend auf dem Prinzip der Vorwärtsfehlerkorrektur, beispielsweise ein Faltungscode mit einem Soft-Decision-Viterbi-Decoder, zum Einsatz. Dies führt insbesondere bei einem stark gestörten physikalischen Kanal zu einer hohen Restfehlerrate nach dem Kanaldecodieren, wodurch die Bildqualität des decodierten Bildes erheblich beeinträchtigt wird.

Aus [3] ist es bekannt, Nutzdaten zweimal hintereinander einer Kanalcodierung zuzuführen und nach Übertragung über den physikalischen Kanal zweimal hintereinander eine Kanaldecodierung durchzuführen (serielle Codeverkettung). Bei der seriellen Codeverkettung werden die Nutzdaten mit einem fehlerkorrigierenden Code codiert (äußerer Code). Die daraus resultierenden Daten werden dann mit einem zweiten (dem inneren) Code codiert. Nach der Übertragung wird zunächst der innere Code kanaldecodiert und dann der äußere Code.

Bei der seriellen Codeverkettung ist bekannt, dass die Decoder Informationen austauschen und dass die Decodierung iterativ erfolgen kann (vgl. [6] und [7]). Iterative Decodierung heißt, dass der äußere Kanaldecoder den decodierten Datenstrom nicht sofort an den Quellendecoder weitergibt, sondern zunächst eine Seiteninformation an den Kanaldecoder für den inneren Code zurückführt. Dieser gibt den in der erneuten Decodierung des inneren Codes erhaltenen Datenstrom an den äußeren Kanaldecoder weiter, der dann den äußeren Code ebenfalls nochmals decodiert. Diese Vorgehensweise kann iterativ wiederholt werden (iterative Decodierung).

Nachteilig an dieser Vorgehensweise ist die durch zweifache Kanalcodierung sogar noch erhöhte Menge erforderlicher Redundanzdaten, was zu einer weiteren Verringerung verfügbarer Nutzdatenrate bei der Übertragung von Daten über einen physikalischen Kanal führt.

[8] Zeigt die Verwendung von à-posteriori Information zur Verbesserung der Kanal decodierung.

Aus [4] ist ein Verfahren zur Videobildcodierung bekannt, bei dem innerhalb des Datenstroms im Rahmen der Quellencodierung ein Synchronisationscode vorgesehen ist, mit dem jeweils eine vorgegebene Position eines Datenstromelements innerhalb eines Teils eines digitalisierten Bildes beschrieben wird.

So kann beispielsweise ein Synchronisationscode eingesetzt werden
- zum Anzeigen des Beginns oder des Endes eines Bildblocks,
- zum Anzeigen des Beginns oder des Endes eines Makroblocks, oder
- auch zum Anzeigen des Beginns oder des Endes eines Bildes.

Weiterhin sind Synchronisationscodes üblicherweise vorgesehen zum Anzeigen von dem Beginn oder dem Ende eines Datenpakets, mittels dem die zu übertragenden quellencodierten Daten übertragen werden sollen.

Auf diese Weise ist es im Rahmen der Quellendecodierung möglich, Bitfolgen innerhalb des empfangenen Datenstroms aufgrund des ermittelten Synchronisationscodes eindeutig einer Position innerhalb des Datenstroms zuzuordnen. In anderen Worten bedeutet dies, dass der Synchronisationscode die Position des Datenstromelements innerhalb des Datenstroms bestimmt.

Weiterhin sind aus [5] Verfahren bekannt, die Synchronisationscodes in einem Datenstrom detektieren.

Der Erfindung liegt das Problem zugrunde, einen Datenstrom mit Nutzdaten und Redundanzdaten zu kanaldecodieren, wobei es möglich ist, bei gegenüber bekannten Verfahren zur Vorwärtsfehlerkorrektur verringerter Menge von Redundanzdaten eine gegenüber üblichen Kanaldecodierungsverfahren verbesserte Fehlererkennung zu ermöglichen.

Das Problem wird durch das Verfahren zum Kanaldecodieren, durch die Vorrichtungen zum Kanaldecodieren, durch das computerlesbare Speichermedium und durch ein Computerprogramm-Element mit den Merkmalen gemäß den unabhängigen Ansprüchen gelöst.

Bei einem Verfahren zum Kanaldecodieren eines Datenstroms mit Nutzdaten und Redundanzdaten, wobei der Datenstrom mindestens eine quellencodierte fehlerbehaftete Bitfolge aufweist, die eine vorgegebene Position innerhalb des Datenstroms kennzeichnet, wobei die entsprechende quellencodierte fehlerfreie Bitfolge eine bekannte Bitfolge ist, wird der Datenstrom kanaldecodiert. Die quellencodierte fehlerbehaftete Bitfolge wird in einem weiteren Schritt aus dem kanaldecodierten Datenstrom ermittelt und der Datenstrom wird erneut kanaldecodiert. Die erneute Kanaldecodierung des Datenstroms erfolgt unter Berücksichtigung der ermittelten quellencodierten fehlerbehafteten Bitfolge.

Da aufgrund der Ermittlung der quellencodierten fehlerbehafteten Bitfolge aus dem kanaldecodierten Datenstrom sowohl die Position beispielsweise eines Synchronisationscodes als auch die mit großer Wahrscheinlichkeit korrekte Bitfolge ermittelt worden ist, liegt somit empfängerseitig zusätzliche Information über die korrekte decodierte Bitfolge vor, die nunmehr bei einer erneuten Kanaldecodierung des Datenstroms zur Verbesserung der Fehlererkennung bzw. der Fehlerkorrektur eingesetzt werden kann.

Eine Vorrichtung zum Kanaldecodieren eines Datenstroms mit Nutzdaten und Redundanzdaten, wobei der Datenstrom mindestens eine quellencodierte fehlerbehaftete Bitfolge aufweist, die eine vorgegebene Position innerhalb des Datenstroms kennzeichnet, wobei die entsprechende quellencodierte fehlerfreie Bitfolge eine bekannte Bitfolge ist, weist einen Prozessor auf, der derart eingerichtet ist, dass folgende Verfahrensschritte durchführbar sind:
- der Datenstrom wird kanaldecodiert,
- die quellencodierte fehlerbehaftete Bitfolge wird ermittelt,
- der Datenstrom wird erneut kanaldecodiert, wobei das erneute Kanaldecodieren des Datenstroms unter Berücksichtigung der ermittelten quellencodierten fehlerbehafteten Bitfolge erfolgt.

Die berücksichtigte/berücksichtigten ermittelte/ermittelten quellencodierte Bitfolge/Bitfolgen kann/können die ermittelte quellencodierte Bitfolge des aktuellen Decodierschritts und/oder in zeitlich vorangegangenen Decodierschritten ermittelte Bitfolgen (zur Ausnutzung der statistischen Korrelationen zwischen aufeinanderfolgenen Bildern) sein.

Weiterhin wird ein computerlesbares Speichermedium bereitgestellt, in dem ein Computerprogramm zum Kanalcodieren eines Datenstroms gespeichert ist. Der Datenstrom weist Nutzdaten und Redundanzdaten auf, wobei der Datenstrom mindestens eine quellencodierte fehlerbehaftete Bitfolge aufweist, die eine vorgegebene Position innerhalb des Datenstroms kennzeichnet, wobei die entsprechende quellencodierte fehlerfreie Bitfolge eine bekannte Bitfolge ist. Wenn das Computerprogramm, das in dem computerlesbaren Speichermedium gespeichert ist, von einem Prozessor ausgeführt wird, werden folgende Verfahrensschritte durchgeführt:
- der Datenstrom wird kanaldecodiert,
- die quellencodierte fehlerbehaftete Bitfolge wird aus dem kanaldecodierten Datenstrom ermittelt,
- der Datenstrom wird erneut kanaldecodiert, wobei das erneute Kanaldecodieren des Datenstroms unter Berücksichtigung der ermittelten quellencodierten fehlerbehafteten Bitfolge erfolgt.

Ein Computerprogramm-Element zum Kanaldecodieren eines Datenstroms mit Nutzdaten und Redundanzdaten kann von einem Prozessor ausgeführt werden. Der Datenstrom weist mindestens eine quellencodierte fehlerbehaftete Bitfolge auf, die eine vorgegebene Position innerhalb des Datenstroms kennzeichnet, wobei die entsprechende quellencodierte fehlerfreie Bitfolge eine bekannte Bitfolge ist. Wenn das Computerprogramm-Element von dem Prozessor ausgeführt wird, werden folgende Verfahrensschritte durchgeführt:
- der Datenstrom wird kanaldecodiert,
- die quellencodierte fehlerbehaftete Bitfolge wird aus dem kanaldecodierten Datenstrom ermittelt,
- der Datenstrom wird erneut kanaldecodiert, wobei das erneute Kanaldecodieren des Datenstroms unter Berücksichtigung der ermittelten quellencodierten fehlerbehafteten Bitfolge erfolgt.

Eine Vorrichtung zum Kanaldecodieren eines Datenstroms mit Nutzdaten und Redundanzdaten, wobei der Datenstrom mindestens eine quellencodierte fehlerbehaftete Bitfolge aufweist, die eine vorgegebene Position innerhalb des Datenstroms kennzeichnet, wobei die entsprechende quellencodierte fehlerfreie Bitfolge eine bekannte Bitfolge ist, weist einen Kanaldecoder zum Kanaldecodieren eines Datenstroms auf. Weiterhin ist eine Ermittlungseinheit zum Ermitteln einer quellencodierten fehlerbehafteten Bitfolge aus dem kanaldecodierten Datenstrom vorgesehen. Die Ermittlungseinheit ist mit dem Kanaldecoder derart verbunden, dass dem Kanaldecoder Information über die quellencodierte fehlerbehaftete Bitfolge zuführbar ist.

Bevorzugte Weiterbildungen der Erfindung ergeben sich aus den abhängigen Ansprüchen.

Die im weiteren beschriebenen Ausgestaltungen der Erfindung beziehen sich sowohl auf das Verfahren als auch auf die Vorrichtungen sowie auf das computerlesbare Speichermedium und das Computerprogramm-Element.

In einer Ausgestaltung der Erfindung ist es vorgesehen, dass beim Ermitteln der quellencodierten fehlerbehafteten Bitfolge jeweils eine Wahrscheinlichkeit dafür ermittelt wird, dass der jeweilige Bitwert der Bitfolge einen bestimmten Wert aufweist. Damit wird im Rahmen der sogenannten Soft-Decision-Decodierung erreicht, dass der Kanaldecoder eine sehr genaue Information über den jeweiligen Bitwert erhält, und somit sehr gut abschätzen kann, wie sicher die dem Kanaldecoder verfügbare Information über die ermittelte quellencodierte fehlerbehaftete Bitfolge ist, wodurch die erreichte Fehlererkennung bzw. Fehlerkorrektur beim erneuten Kanaldecodieren des Datenstroms weiter verbessert wird.

Die bekannte Bitfolge kann ein Synchronisationscode eines Datenstromelements des Datenstroms sein zum eindeutigen Bestimmen der Position des Datenstromelements innerhalb des Datenstroms.

So kann beispielsweise das Datenstromelement einen Teil eines digitalisierten Bildes beschreiben und in diesem Zusammenhang kann mit diesem Synchronisationscode zumindest eine der folgenden Positionen gekennzeichnet werden:
- der Beginn oder das Ende eines Bildblocks,
- der Beginn oder das Ende eines Makroblocks,
- der Beginn oder das Ende eines Bildes.

Werden Datenpakete zur Übertragung der Nutzdaten verwendet, so kann der Synchronisationscode auch den Beginn oder das Ende eines Datenpakets kennzeichnen, beispielsweise durch eine vorgegebene Anzahl von Bits mit einem ersten vorgegebenen Binärwert, eingerahmt durch zwei Bits mit einem zweiten vorgegebenen Binärwert (erster Binärwert: logisch "0", zweiter Binärwert: logisch "1").

Auf diese Weise wird eine im Rahmen der Quellendecodierung ohnehin erhaltene Information zur Synchronisation der einzelnen Bildelemente oder allgemein des Datenstroms eingesetzt, um sowohl Fehler zu erkennen, als auch die erkannten Fehler und die zugehörige Position des Fehlers innerhalb des Datenstroms an den Kanaldecoder zu übermitteln, wodurch bei erneuter Kanaldecodierung eine weitere Erhöhung der Fehlererkennung bzw. Fehlerkorrektur erreicht wird.

In einer Ausgestaltung der Erfindung erfolgt die Kanalcodierung mittels eines Faltungscodes, insbesondere mittels eines gelochten Faltungscodes, wie er in [1] beschrieben ist.

Bei den Verfahren zur Decodierung von gelochten Faltungscodes wird eine sehr gute Verarbeitung ermittelter zusätzlich gesicherter Information über die Decodierung zu einer deutlichen Verbesserung der Fehlererkennungsleistung eingesetzt.

Die quellencodierte fehlerbehaftete Bitfolge kann mittels Vergleichs mit der quellencodierten fehlerfreien bekannten Bitfolge ermittelt werden, beispielsweise durch ein einfaches Korrelationsverfahren, das nach einem bestimmten vorgegebenen Bitmuster innerhalb des empfangenen Datenstroms sucht und bei ausreichend sicherer Erkennung eines solchen Bitmusters das erkannte Bitmuster als quellencodierte fehlerbehaftete Bitfolge annimmt. Das einfachste Korrelationsverfahren ist ein 1-zu-1-Vergleich der bekannten quellencodierten fehlerfreien Bitfolge mit den Bits in dem kanaldecodierten Datenstrom. Prinzipiell können alle aus der Synchronisation bekannten Verfahren eingesetzt werden, wie sie beispielsweise in [5] beschrieben sind.

Es kann jedoch auch eine zusätzliche Information, die mittels statistischer Analysen bestimmter vorangegangener decodierter Bilder oder auch typischer Bildsequenzen ermittelt worden ist, eingesetzt werden, um im Rahmen der erneuten Kanaldecodierung zu einer verbesserten Fehlererkennungsleistung zu führen.

So kann beispielsweise eine statistische Analyse auf vorangegangene decodierte Bilder, beispielsweise Videobilder im Rahmen einer Videokonferenz, durchgeführt werden und aufgrund der daraus gewonnenen a-priori-Information, beispielsweise der bestimmten Bitwechselwahrscheinlichkeiten,können für das aktuelle Bild, das heißt für Bildblöcke in dem aktuellen Bild statistische Abhängigkeiten örtlich übereinstimmender Bereiche mit zeitlich vorangegangenen Bildern verglichen werden, um damit übereinstimmende Bereiche mit hoher Wahrscheinlichkeit zu ermitteln. Müssten gemäß der statistischen Analyse, beispielsweise aufgrund sehr geringer Bitwechselwahrscheinlichkeiten, Bits in einem unbewegten Bildbereich des Bildhintergrundes eigentlich unverändert gegenüber den Bits im gleichen Bereich des vorangegangenen Bildes sein, so kann angenommen werden, dass ein Bitfehler aufgrund einer Störung in dem physikalischen Kanal aufgetreten ist. Dies kann dem Kanaldecoder wiederum als Zusatzinformation mitgeteilt werden und kann von dem Kanaldecoder im Rahmen der weiteren Kanaldecodierung wiederum eingesetzt werden, um die Fehlererkennung bzw. Fehlerkorrektur zu verbessern.

Somit eignet sich die Erfindung insbesondere zum Einsatz im Rahmen einer Videokonferenz, da bei einer Videokonferenz nur eine geringe Menge von Objekten bewegt ist, und ein großer Bereich des Hintergrunds unverändert bleibt, womit im wesentlichen bei aufeinanderfolgen Bildern in übereinstimmenden Bildbereichen die Bits eine sehr ähnliche Struktur aufweisen, wodurch das oben beschriebene Analyseverfahren sehr gute Ergebnisse liefert.

Die entsprechenden Analyseverfahren können selbstverständlich auch auf einzelne Bildobjekte, beispielsweise auf den Korpus oder den Kopf des Objekts, die jeweils eine gleichmäßige Bewegung durchführen, angewendet werden.

Da die Information insbesondere über Synchronisationscodes im Rahmen der Quellendecodierung ohnehin erhältlich ist, ist es vorteilhaft, die Ermittlung der quellencodierten fehlerbehafteten Bitfolge im Rahmen der Quellendecodierung vorzunehmen und diese Information anschließend dem Kanaldecoder zur erneuten Kanaldecodierung des Datenstroms zuzuführen. Da auf diese Weise die Struktur der Quellendecoder nur minimal verändert werden muss, führt dies zu einer sehr einfachen und kostengünstigen Realisierung der Kanaldecodierung.

Ein Ausführungsbeispiel der Erfindung ist in den Figuren dargestellt und wird im weiteren näher erläutert.

Es zeigen
- Figur 1: eine Skizze einer Anordnung zur Quellencodierung/Kanalcodierung und Kanaldecodierung/Quellendecodierung von einer Folge von Videobildern gemäß einem ersten Ausführungsbeispiel;
- Figur 2: eine Skizze eines Modells zur digitalen Nachrichtenübertragung;
- Figuren 3A bis 3D: jeweils die Struktur eines Datenelements mit jeweils einem Synchronisationscode am Anfang und am Ende des Datenpakets gemäß einem Ausführungsbeispiel;
- Figur 4: eine Skizze mehrerer Testbilder, anhand der die Analyse der statistischen Abhängigkeiten einzelner Bits in einem Videobild von einem vorangegangenen Videobild dargestellt ist, sowie eine Matrix mit Bitwechselwahrscheinlichkeiten eines Videobildes, die sich aus der statistischen Analyse der Testbilder ergeben.

### Erstes Ausführungsbeispiel:

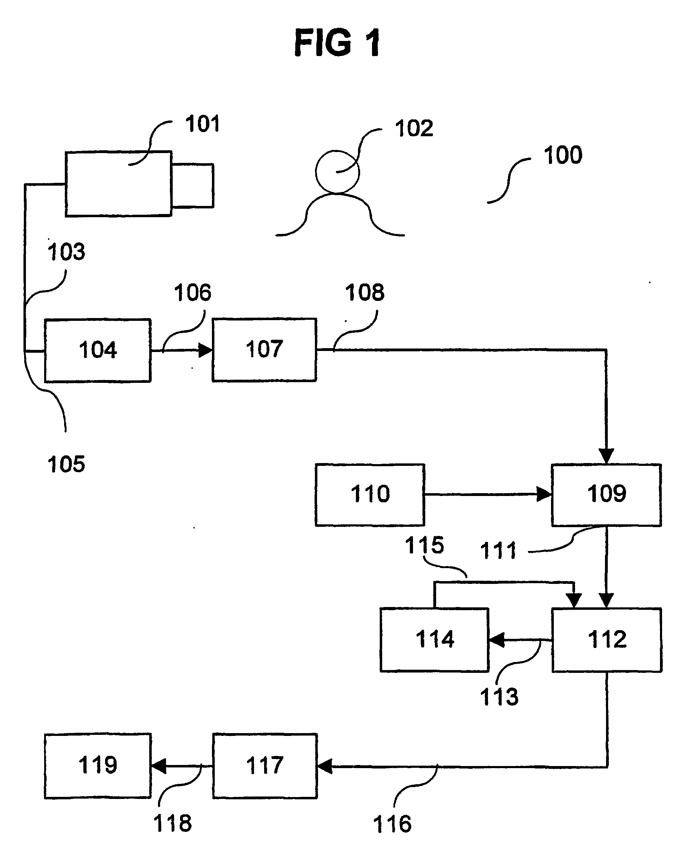

**Fig.1** zeigt ein Videokommunikationssystem 100 mit einer Kamera 101, die Bilder eines Benutzers 102 des Videokommunikationssystems 100 aufnimmt. Die Kamera 101 ist über eine Verbindung 103 mit einem Quellencoder 104 verbunden. In dem Quellencoder 104 werden die von der Kamera aufgenommenen und digitalisierten Videobilder (Quellendatenstrom 105) gemäß dem MPEG2-Standard quellencodiert.

Gemäß dem MPEG2-Standard ist in einem sich ergebenden quellencodierten Quellendatenstrom 106 ein Synchronisationscode 301 für einen Makroblock enthalten, mit dem der Beginn eines Makroblocks eines Videobildes eindeutig gekennzeichnet wird. Nach dem Synchronisationscode 301 ist gemäß dem MPEG-2-Standard eine Bitfolge in dem Datenpaket als Nutzdaten 302 enthalten, das den Inhalt des Makroblocks beschreibt, beispielsweise die Information der Helligkeit der einzelnen Bildpunkte der in dem Makroblock enthaltenen Bildblöcke.

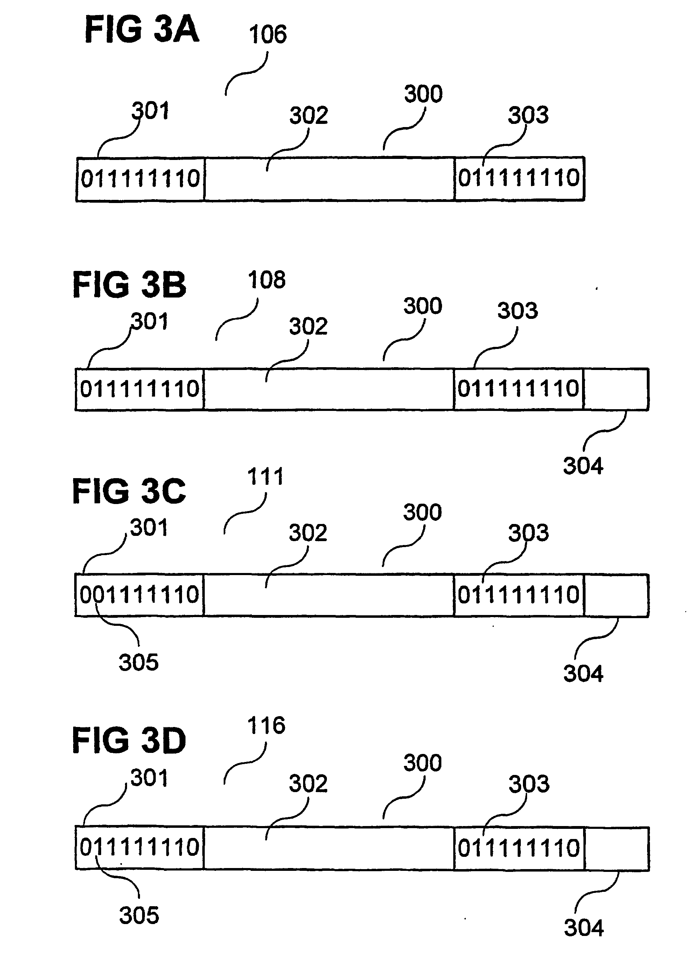

In einem weiteren Synchronisationscode 303 wird für das Datenpaket 300 des Makroblocks das Ende des Datenpaket 300 gekennzeichnet. Der erste Synchronisationscode 301 und der zweite Synchronisationscode 303 sind eindeutig vorgegebene Bitfolgen, gemäß diesem Ausführungsbeispiel eine vorgegebene Anzahl Bits mit einem logischen Wert "1", eingerahmt durch zwei Bits mit dem logischen Binärwert "0" (vgl. **Fig.3A**).

Der quellencodierte Datenstrom 106 wird einem Kanalcoder 107, gemäß diesem Ausführungsbeispiel einem Faltungscoder, der gemäß dem in [2] beschriebenen Verfahren den quellencodierten Datenstrom 106 kanalcodiert zu einem kanalcodierten Datenstrom 108, zugeführt.

Der kanalcodierte Datenstrom 108 wird nach durchgeführter Modulation (nicht dargestellt) über einen physikalischen Kanal 109, über eine Funkverbindung oder eine Telefonverbindung, zu einem Empfänger übertragen.

Während der Übertragung kommt es durch Rauschen auf dem physikalischen Kanal 109 zu einer Störung 110. Der durch die Störung 110 gebildete gestörte kanalcodierte Datenstrom 111 wird von einem Empfänger empfangen und nach erfolgter Demodulation einem Kanaldecoder 112 zugeführt.

Durch die Kanalcodierung wird, wie in **Fig.3B** dargestellt, dem Datenpaket 300 Redundanzinformation 304 zugefügt, damit mögliche Fehler aufgrund der Störung 110 während der Übertragung über den physikalischen Kanal 109 im Rahmen der Kanaldecodierung erkannt werden können.

Gemäß dem aus [2] bekannten Verfahren wird in den Kanaldecoder 112 eine Kanaldecodierung des gestörten kanalcodierten Datenstroms 111 durchgeführt. Der durch die Kanaldecodierung gebildete kanaldecodierte Datenstrom 113 wird einer Ermittlungseinheit 114 zugeführt.

In der Ermittlungseinheit wird mittels eines Korrelationsverfahrens die durch den Synchronisationscode vorgegebene eindeutige Bitfolge in dem kanaldecodierten Datenstrom ermittelt.

Wie in **Fig.3C** dargestellt, wird für die weitere Ausführung gemäß dem ersten Ausführungsbeispiel angenommen, dass in dem ersten Synchronisationscode 301 in dessen zweitem Bit 305 aufgrund des Korrelationsverfahrens, wie es in [5] beschrieben ist, mit einer großen Wahrscheinlichkeit erkannt wird/wurde, dass der entsprechende Bereich der fehlerbehafteten quellencodierten Bitfolge dem ersten Synchronisationscode 301 entspricht.

Da ja dem Empfänger bekannt ist, welche Bitfolge der fehlerfreie erste Synchronisationscode 301 aufweist, wird das gemäß diesem Ausführungsbeispiel fehlerhafte zweite Bit 305 des ersten Synchronisationscodes 301 erkannt und korrigiert und die entsprechende Information wird dem Kanaldecoder 112 in einer Rückkoppelschleife 115 zugeführt.

Der Kanaldecoder 112 kanaldecodiert den Datenstrom ein zweites Mal, nunmehr jedoch mit der zusätzlichen, von der Ermittlungseinheit 114 erzeugten Information über das zweite Bit 305 des ersten Synchronisationscodes 301 des entsprechenden Makroblocks.

Auch wenn gemäß diesem Ausführungsbeispiel nur ein trivialer Fall dargestellt wird, um die Erfindung zu verdeutlichen, so ist es jedoch bei einem entsprechend längeren Synchronisationscode oder auch bei entsprechend unterschiedlichen Korrelationsverfahren ebenso möglich, mehrere Bitfehler mit einer hohen Wahrscheinlichkeit zu erkennen und diese Information dem Kanaldecoder 113 zuzuführen, die dann im Rahmen einer zweiten Kanaldecodierung des Datenstroms verwendet wird, wodurch im Rahmen der zweiten Kanaldecodierung des Datenstroms eine verbesserte Fehlererkennung und Fehlerkorrektur erreicht wird.

Der gemäß der zweiten Kanaldecodierung erzeugte zweite kanaldecodierte Datenstrom 116 wird einem Quellendecoder 117, der gemäß dem MPEG-2-Verfahren eine Quellendecodierung des empfangenen zweiten kanaldecodierten Datenstroms 116 ausführt, zugeführt.

Das durch den Quellendecoder 117 rekonstruierte Videobild 118 wird auf einem Bildschirm 119 einem Benutzer des Videokommunikationssystems 100 dargestellt.

Wie in **Fig.3D** dargestellt ist, ist bei der zweiten Kanaldecodierung durch den Kanaldecoder 112 das zweite Bit 305 des ersten Synchronisationscodes 301 wieder auf den korrekten ersten Binärwert logisch "1" gesetzt. Dadurch ist eine korrekte Decodierung des ersten Synchronisationscodes 301 durch das erfindungsgemäße Verfahren erreicht.

### Zweites Ausführungsbeispiel:

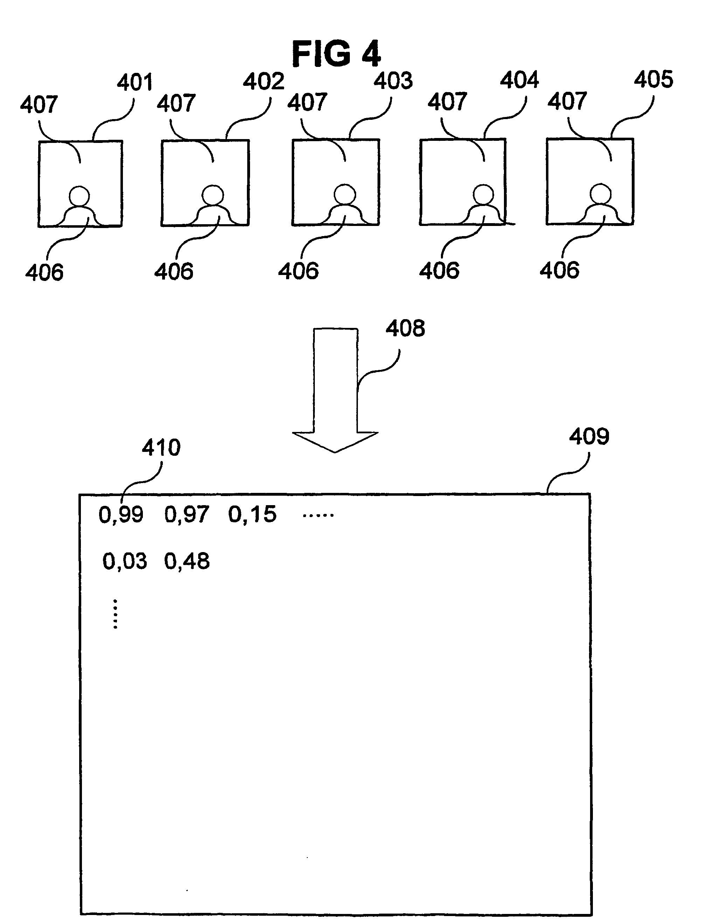

Gemäß dem zweiten Ausführungsbeispiel wird vor der eigentlichen Kanaldecodierung für eine Folge von Testvideobildern 401, 402, 403, 404, 405 (vgl. **Fig.4**), eine statistische Analyse des Bildinhalts durchgeführt.

Wie aus den Testbildern 401, 402, 403, 404, 405 ersichtlich ist, ist ein Benutzer des Videokommunikationssystems in dem jeweiligen Bild als Bildobjekt 406 enthalten. Außerdem ist ein Bildhintergrund 407 in jedem Videobild enthalten. Auf die Testbilder 401, 402, 403, 404, 405 wird eine statistische Analyse der Änderung der einzelnen Bits in dem Videobild zwischen einzelnen Videobildern durchgeführt (symbolisiert durch Pfeil 408).

Jedes Videobild wird durch eine Folge von Bits codiert. Bei einer Auflösung von 1024 x 768 Bildpunkten in einem Bild, wobei jeder Bildpunkt mit 8 Bit als Helligkeitsinformation codiert wird, ergeben sich pro Videobild 6.291.456 Bit.

Aufgrund der Analyse der Testbilder ergibt sich eine Testmatrix 409, in der einzelne Bitwechselwahrscheinlichkeiten 410 gespeichert sind, wobei mit jeder Bitwechselwahrscheinlichkeit 410 angegeben ist, mit welcher Wahrscheinlichkeit ein Bit in dem Bitstrom zwei aufeinander folgender Videobilder den logischen Wert wechselt. Es ergeben sich gemäß diesem Ausführungsbeispiel somit in der Testmatrix 409 6.291.456 Bitwechselwahrscheinlichkeiten 410.

Gemäß diesem zweiten Ausführungsbeispiel wird somit aufgrund der semantischen Analyse zeitlich aufeinander folgender Bilder im Rahmen einer Videokonferenz mittels der Testmatrix 409 in der Ermittlungseinheit 114 eine Wahrscheinlichkeit in der Übereinstimmung einer fehlerbehafteten Bitfolge mit der fehlerfreien Bitfolge gemäß der statistischen Analyse der Testbilder ermittelt.

Gemäß dem in [5] beschriebenen Verfahren werden die Synchronisationsmarken im kanaldecodierten Videodatenstrom ermittelt. Diese Information wird dann ebenfalls bei einer erneuten Kanaldecodierung als a-priori Information verwendet.

Es werden somit statistische Abhängigkeiten zwischen Bitfolgen aufeinander folgender Videobildblöcke aufgrund der Analyse zuvor empfangener und decodierter Bilder ermittelt und damit Wahrscheinlichkeiten für eine vorgegebene Bitfolge in dem Datenstrom angegeben.

Dies bedeutet, dass man für Teile des Bitstroms gemäß dem aus [5] bekannten Verfahren eine a-priori-Information über deren Auftreten in zeitlich nachfolgenden Bildern erhält.

Als a-priori-Information kann somit beispielsweise eine Bitwechselwahrscheinlichkeit verwendet werden. Dazu analysiert man zusätzlich für typisches Bildmaterial, beispielsweise für eine Folge von Bildern einer Testsequenz im Rahmen einer Videokonferenz für jedes Bit in dem Datenstrom, mit welcher Häufigkeit es sich bei zeitlich aufeinander folgenden Bildblöcken aufeinander folgender Bilder ändert.

Dies erfolgt gemäß dem zweiten Ausführungsbeispiel, indem die bekannte Struktur des codierten Videodatenstroms zum Ermitteln der Bitwechselwahrscheinlichkeiten genutzt wird. Aufgrund der bekannten Struktur is es beispielsweise bekannt, dass ein Zusammenhang zwischen bestimmten Bildregionen und Gruppen von Bits im codierten Videodatenstrom besteht, beispielsweise bei einem Gruoup of Blocks (GOB). Diese Gruppen von Bits werden im weiteren auch als Regionen bezeichnet.

Der codierte Videodatenstrom (Bitstrom) wird daraufhin untersucht, gemäß welcher statistischen Beschreibung sich die Bits innerhalb der Regionen von Bild zu Bild ändern. Aus der statistischen Beschreibung wird für jedes Bit einer Region eine Bitwechselwahrscheinlichkeit ermittelt, d.h. es wird die Wahrscheinlichkeit dafür ermittelt, dass sich der Wert des jeweiligen Bits von einem Bild zu verglichen mit dem entsprechenden Bit des zeitlich folgenden Bildes ändert.

Die ermittelte Bitwechselwahrscheinlichkeiten werden dem Kanaldecoder 112 wiederum mitgeteilt, der diese Information im Rahmen der zweiten Kanaldecodierung des gestörten kanalcodierten Datenstroms 111 als a priori-Information verwendet.

Im weiteren werden einige Alternativen zu den oben beschriebenen Ausführungsbeispielen dargelegt.

Die Erfindung ist weder auf eine Übertragung von Videobildern, noch auf einen Faltungscode zur Kanalcodierung bzw. Kanaldecodierung beschränkt.

Anschaulich ist die Erfindung darin zu sehen, dass im Rahmen einer Quellendecodierung ohnehin erhaltene Information zur Ermittlung von Fehlern im fehlerbehafteten kanaldecodierten Datenstrom ermittelt wird, die entsprechende Fehlerinformation dem Kanaldecoder zugeführt wird und im Rahmen einer zweiten Kanaldecodierung des gestörten Datenstroms berücksichtigt wird.

Die Ermittlungseinheit 114 kann sowohl in dem Quellendecoder 117 als auch in dem Kanaldecoder 112 selbst integriert sein.

Ferner ist anzumerken, dass die Funktionalität gemäß dem ersten Ausführungsbeispiel und gemäß dem zweiten Ausführungsbeispiel auch kombiniert im Rahmen einer Kanaldecodierung eingesetzt werden kann, wodurch die erreichbare Fehlererkennung und Fehlerkorrektur im Rahmen der zweiten Kanaldecodierung des gestörten kanaldecodierten Datenstroms 111 weiter verbessert wird.

In diesem Dokument sind folgende Veröffentlichungen zitiert:
[1] B. Friedrichs, Kanalcodierung, Springer, ISBN 3-540-58232-0, Seite 1 - 29, 1996
[2] J. Hagenauer, Rate-Compatible Punctured Convolutional Codes (RCPC-Codes) and their Applications, IEEE-Transactions on Communications, Vol. 36, No. 4, S. 389-400, April 1988
[3] Shu Lin, David Costello: "Error Control Coding - Fundamentals and Applications. Prentice Hall S. 278 ff, S.535 ff, ISBN 0-13-282796-X
[4] D. Le Gall, MPEG: A Video Compression Standard for Multimedia Applications, Communications of the ACM, Vol. 34, Nr. 4, S. 47 - 58, April 1991
[5] Heinrich Meyr, Marc Moeneclaey, Stefan Fechter, Digital Communication Receivers, Volume 2, Synchronisation, Channel Estimation and Signal Processing, John Wiley & Sons, ISBN 0471502758
[6] Joachim Hagenauer, Elke Offer, und Lutz Papke: "Iterative Decoding of Binary Block and Convolutional Codes", IEEE Transactions on Information Theory, vol. 42, S. 429 - 445, 1996
[7] AIGN, S.: 'Error concealment, early re-synchronization, and iterative decoding ', 1997 IEEE INTERNATIONAL CONFERENCE ON COMMUNICATIONS. , Montreal, Que., Canada, 08. Juni 1997-12. Juni 1997, Band 3, Nr. , Seiten 1654 - 1658
[8] HAGENAUER, J.: 'Source-Controlled Channel Decoding', IEEE TRANSACTIONS ON COMMUNICATIONS, NEW YORK, US, September 1995, Band 43, Nr. 9, Seiten 2449 - 2457

## Patentansprüche

1. Verfahren zum Kanaldecodieren eines Datenstroms mit Nutzdaten und Redundanzdaten, wobei der Datenstrom mindestens eine quellencodierte fehlerbehaftete Bitfolge aufweist, wobei die entsprechende quellencodierte fehlerfreie Bitfolge eine bekannte Bitfolge ist,
• bei dem der Datenstrom kanaldecodiert wird,
• bei dem die quellencodierte fehlerbehaftete Bitfolge aus dem kanaldecodierten Datenstrom ermittelt wird, wobei eine Fehlerinformation über die quellencodierte fehlerbehaftete Bitfolge ermittelt wird,
• bei dem der Datenstrom erneut kanaldecodiert wird, wobei das erneute Kanaldecodieren des Datenstroms unter Berücksichtigung der Fehlerinformation erfolgt.

2. Verfahren nach Anspruch 1,
bei dem beim Ermitteln der quellencodierten fehlerbehafteten Bitfolge jeweils eine Wahrscheinlichkeit dafür ermittelt wird, dass der jeweilige Bitwert der Bitfolge einen bestimmten Wert aufweist.

3. Verfahren nach Anspruch 1 oder 2,
bei dem die bekannte Bitfolge ein Synchronisationscode eines Datenstromelements des Datenstroms ist zum eindeutigen Bestimmen einer Position des Datenstromelements innerhalb des Datenstroms.

4. Verfahren nach Anspruch 3,
• bei dem das Datenstromelement einen Teil eines digitalisierten Bildes beschreibt,
• bei dem mit dem Synchronisationscode zumindest eine der folgenden Positionen gekennzeichnet wird:
- der Beginn oder das Ende eines Bildblocks,
- der Beginn oder das Ende eines Makroblocks,
- der Beginn oder das Ende eines Bildes.

5. Verfahren nach Anspruch 3,
bei dem mit dem Synchronisationscode der Beginn oder das Ende eines Datenpakets gekennzeichnet wird.

6. Verfahren nach einem der Ansprüche 1 bis 5,
bei dem die Kanalcodierung mittels eines Faltungscodes erfolgt.

7. Verfahren nach Anspruch 6,
bei dem die Kanalcodierung mittels eines gelochten Faltungscodes erfolgt.

8. Verfahren nach einem der Ansprüche 1 bis 7,
bei dem das Ermitteln der quellencodierten fehlerbehafteten Bitfolge im Rahmen des Quellendecodierens der kanaldecodierten Bitfolge erfolgt.

9. Verfahren nach einem der Ansprüche 1 bis 8,
bei dem die Ermittlung der quellencodierten fehlerbehafteten Bitfolge mittels eines Vergleichs des kanaldecodierten Datenstroms mit der quellencodierten fehlerfreien bekannten Bitfolge erfolgt.

10. Verfahren nach Anspruch 9,
bei dem zum Vergleichen ein Körrelationsverfahren eingesetzt wird, und die quellencodierte fehlerbehaftete Bitfolge als ermittelt angenommen wird, wenn der Vergleich einen Korrelationswert ergibt, der einen vorgegebenen Übereinstimmungsgrad übersteigt.

11. Verfahren nach Anspruch 3 und einem der Ansprüche 4 bis 10,
• bei dem das Datenstromelement einen Teil eines digitalisierten Bildes beschreibt,
• bei dem die quellencodierte fehlerfreie Bitfolge im wesentlichen übereinstimmt mit einer entsprechenden quellencodierten fehlerfreien Bitfolge eines vorangegangenen Datenstromelements.

12. Verfahren nach Anspruch 11,
bei dem die quellencodierte fehlerfreie Bitfolge eine Bitfolge ist, die den Inhalt des gleichen Bereichs eines Bildes beschreibt wie die entsprechende quellencodierte fehlerfreie Bitfolge des vorangegangenen Datenstromelements des vorangegangenen Bildes.

13. Verfahren nach Anspruch 12,
bei dem jedem Bit der quellencodierten fehlerfreien Bitfolge eine Übereinstimmungswahrscheinlichkeit mit dem entsprechenden Bit der quellencodierten fehlerfreien Bitfolge des vorangegangenen Datenstromelements zugeordnet ist, die im Rahmen des erneuten Kanaldecodierens berücksichtigt wird.

14. Verfahren nach einem der Ansprüche 1 bis 13, eingesetzt im Rahmen einer Videokonferenz.

15. Vorrichtung zum Kanaldecodieren eines Datenstroms mit Nutzdaten und Redundanzdaten, wobei der Datenstrom mindestens eine quellencodierte fehlerbehaftete Bitfolge aufweist, wobei die entsprechende quellencodierte fehlerfreie Bitfolge eine bekannte Bitfolge ist, mit
• einem Kanaldecoder zu einem wiederholten Kanaldecodieren des Datenstroms,
• einer Ermittlungseinheit zum Ermitteln einer quellencodierten fehlerbehafteten Bitfolge aus dem kanaldecodierten Datenstrom, wobei bei der Ermittlung der quellencodierten fehlerbehafteten Bitfolge eine Fehlerinformation über die quellencodierte fehlerbehaftete Bitfolge ermittelbar ist,
• wobei die Ermittlungseinheit mit dem Kanaldecoder verbunden ist derart, dass dem Kanaldecoder die Fehlerinformation über die quellencodierte fehlerbehaftete Bitfolge zuführbar ist und dieser bei der wiederholten Kanaldecodierung des Datenstroms die Fehlerinformation berücksichtigt.

16. Vorrichtung nach Anspruch 15,
mit einem Quellendecoder, der die Ermittlungseinheit aufweist.

17. Computerlesbares Speichermedium, in dem ein Computerprogramm zum Kanaldecodieren eines Datenstroms mit Nutzdaten und Redundanzdaten gespeichert ist, wobei der Datenstrom mindestens eine quellencodierte fehlerbehaftete Bitfolge aufweist, wobei die entsprechende quellencodierte fehlerfreie Bitfolge eine bekannte Bitfolge ist, das, wenn es von einem Prozessor ausgeführt wird, folgende Verfahrensschritte aufweist:
• der Datenstrom wird kanaldecodiert,
• die quellencodierte fehlerbehaftete Bitfolge wird aus dem kanaldecodierten Datenstrom ermittelt, wobei eine Fehlerinformation über die quellencodierte fehlerbehaftete Bitfolge ermittelt wird,
• der Datenstrom wird erneut kanaldecodiert, wobei das erneute Kanaldecodieren des Datenstroms unter Berücksichtigung der Fehlerinformation erfolgt.

18. Computerprogrammelement zum Kanaldecodieren eines Datenstroms mit Nutzdaten und Redundanzdaten, wobei der Datenstrom mindestens eine quellencodierte fehlerbehaftete Bitfolge aufweist, wobei die entsprechende quellencodierte fehlerfreie Bitfolge eine bekannte Bitfolge ist, das, wenn es von einem Prozessor ausgeführt wird, folgende Verfahrensschritte aufweist:
• der Datenstrom wird kanaldecodiert,
• die quellencodierte fehlerbehaftete Bitfolge wird aus dem kanaldecodierten Datenstrom ermittelt, wobei eine Fehlerinformation über die quellencodierte fehlerbehaftete Bitfolge ermittelt wird,
• der Datenstrom wird erneut kanaldecodiert, wobei das erneute Kanaldecodieren des Datenstroms unter Berücksichtigung der Fehlerinformation erfolgt.

## Claims

1. Method for channel decoding a data stream containing useful data and redundant data, the data stream exhibiting at least one source-coded errored bit sequence, the corresponding source-coded error-free bit sequence being a known bit sequence,
• in which the data stream is channel decoded,
• in which the source-coded errored bit sequence is determined from the channel-decoded data stream, and an error information item about the source-coded errored bit sequence is determined,
• in which the data stream is again channel decoded, the repeated channel decoding of the data stream being effected by taking into consideration the error information item.

2. Method according to Claim 1,
in which, during the determining of the source-coded errored bit sequence, a probability that the respective bit value of the bit sequence exhibits a particular value is determined in each case.

3. Method according to Claim 1 or 2,
in which the known bit sequence is a synchronization code of a data stream element of the data stream for unambiguously determining a position of the data stream element within the data stream.

4. Method according to Claim 3,
• in which the data stream element describes a part of a digitized frame,
• in which the synchronization code identifies at least one of the following positions:
- the beginning or the end of a block,
- the beginning or the end of a macroblock,
- the beginning or the end of a frame.

5. Method according to Claim 3,
in which the synchronization code identifies the beginning or the end of a data packet.

6. Method according to one of Claims 1 to 5,
in which the channel coding is performed by means of a convolutional code.

7. Method according to Claim 6,
in which the channel coding is performed by means of a punctured convolutional code.

8. The method according to one of Claims 1 to 7,
in which the source-coded errored bit sequence is determined during the source decoding of the channel-decoded bit sequence.

9. Method according to one of Claims 1 to 8,
in which the source-coded errored bit sequence is determined by means of a comparison of the channel-decoded data stream with the source-coded error-free known bit sequence.

10. The method according to Claim 9,
in which a correlation method is used for the comparing and the source-coded errored bit sequence is assumed to be determined if the comparison produces a correlation value which exceeds a predetermined degree of correspondence.

11. Method according to Claim 3 and one of Claims 4 to 10,
• in which the data stream element describes a part of a digitized frame,
• in which the source-coded error-free bit sequence essentially corresponds to a corresponding source-coded error-free bit sequence of a preceding data stream element.

12. Method according to Claim 11,
in which the source-coded error-free bit sequence is a bit sequence which describes the content of the same area of a frame as the corresponding source-coded error-free bit sequence of the preceding data stream element of the preceding frame.

13. Method according to Claim 12,
in which to each bit of the source-coded error-free bit sequence, a probability of correspondence with the corresponding bit of the source-coded error-free bit sequence of the preceding data stream element is allocated which is taken into consideration during the repeated channel decoding.

14. Method according to one of Claims 1 to 13, used during a video conference.

15. Device for channel decoding a data stream containing useful data and redundant data, the data stream exhibiting at least one source-coded errored bit sequence, the corresponding source-coded error-free bit sequence being a known bit sequence, comprising
• a channel decoder for the repeated channel decoding of the data stream,
• a determining unit for determining a source-coded errored bit sequence from the channel-decoded data stream, in which an error information item about the source-coded errored bit sequence can be determined during the determination of the source-coded errored bit sequence,
• the determining unit being connected to the channel decoder in such a manner that the error information item about the source-coded errored bit sequence can be supplied to the channel decoder and the latter takes into consideration the error information item during the repeated channel decoding of the data stream.

16. Device according to Claim 15,
comprising a source decoder which exhibits the determining unit.

17. Computer-readable storage medium in which a computer program for channel decoding a data stream containing useful data and redundant data is stored, the data stream exhibiting at least one source-coded errored bit sequence, the corresponding source-coded error-free bit sequence being a known bit sequence, which program, when it is executed by a processor, exhibits the following method steps:
• the data stream is channel decoded,
• the source-coded errored bit sequence is determined from the channel-decoded data stream, and an error information item about the source-coded errored bit sequence is determined,
• the data stream is again channel decoded, the repeated channel decoding of the data stream being effected by taking into consideration the error information item.

18. Computer program element for channel decoding a data stream containing useful data and redundant data, the data stream exhibiting at least one source-coded errored bit sequence, the corresponding source-coded error-free bit sequence being a known bit sequence which, when it is executed by a processor, exhibits the following method steps:
• the data stream is channel decoded,
• the source-coded errored bit sequence is determined from the channel-decoded data stream, and an error information item about the source-coded errored bit sequence is determined,
• the data stream is again channel decoded, the repeated channel decoding of the data stream being effected by taking into consideration the error information item.

## Revendications

1. Procédé pour le décodage canal dans un flux de données comprenant des données utiles et des données redondantes, le flux de données présentant au moins une séquence de bits préalablement soumise à un codage source et contenant des erreurs, la séquence de bits correspondante, préalablement soumise à un codage source et exempte d'erreurs étant une séquence de bits connue,
- dans lequel le flux de données est soumis à un décodage canal,
- dans lequel la séquence de bits préalablement soumise à un codage source et contenant des erreurs est déterminée à partir du flux de données ayant subi un décodage canal, une information d'erreurs concernant la séquence de bits préalablement soumise à un codage source et comprenant des erreurs étant déterminée,
- dans lequel le flux de données est soumis à un décodage canal réitéré, le décodage canal réitéré dans le flux de données étant effectué sous considération de l'information d'erreurs.

2. Procédé selon la revendication 1,
dans lequel, lors de la détermination de la séquence de bits préalablement soumise à un codage source et contenant des erreurs, une probabilité selon laquelle chaque valeur binaire de la séquence de bits présente une certaine valeur est déterminée.

3. Procédé selon l'une quelconque des revendications 1 ou 2,
dans lequel la séquence de bits connue est un code de synchronisation d'un élément du flux de données, pour la détermination indubitable d'une position de l'élément du flux de données au sein du flux de données.

4. Procédé selon la revendication 3,
- dans lequel l'élément du flux de données décrit une partie d'une image numérisée,
- dans lequel le code de synchronisation caractérise au moins l'une des positions suivantes :
- le début ou la fin d'un bloc d'images,
- le début ou la fin d'un bloc de macros,
- le début ou la fin d'une image.

5. Procédé selon la revendication 3,
dans lequel le code de synchronisation caractérise le début ou la fin d'un paquet de données.

6. Procédé selon l'une quelconque des revendications 1 à 5,
dans lequel le codage canal est effectué à l'aide d'un code convolutif.

7. Procédé selon la revendication 6,
dans lequel le codage canal est effectué à l'aide d'un code convolutif perforé.

8. Procédé selon l'une quelconque des revendications 1 à 7,
dans lequel la définition de la séquence de bits préalablement soumise à un codage source et contenant des erreurs est effectuée dans le cadre du décodage source de la séquence de bits ayant subi un décodage canal.

9. Procédé selon l'une quelconque des revendications 1 à 8,
dans lequel la détermination de la séquence de bits préalablement soumise à un codage source et contenant des erreurs est effectuée par comparaison du flux de données ayant subi un décodage canal avec la séquence de bits préalablement soumise à un codage source et exempte d'erreurs.

10. Procédé selon la revendication 9,
dans lequel un procédé de corrélation est utilisé pour la comparaison et la séquence de bits préalablement soumise à un codage source et contenant des erreurs est réputée déterminée, s'il résulte de la comparaison une valeur de corrélation dépassant un degré de correspondance prédéfini.

11. Procédé selon la revendication 3 et l'une quelconque des revendications 4 à 10,
- dans lequel l'élément du flux de données décrit une partie d'une image numérisée,
- dans lequel la séquence de bits préalablement soumise à un codage source et exempte d'erreurs correspond sensiblement à une séquence de bits préalablement soumise à un codage source et exempte d'erreurs d'un élément précédent dans le flux de données.

12. Procédé selon la revendication 11,
dans lequel la séquence de bits préalablement soumise à un codage source et exempte d'erreurs est une séquence de bits décrivant le contenu de la même zone d'une image que la séquence de bits correspondante préalablement soumise à un codage source et exempte d'erreurs de l'élément précédent dans le flux de données de l'image précédente.

13. Procédé selon la revendication 12,
dans lequel une probabilité de correspondance avec le bit correspondant de la séquence de bits préalablement soumise à un codage source et exempte d'erreurs de l'élément précédent dans le flux de données et qui est prise en considération dans le cadre du décodage canal réitéré est affectée à chaque bit de données de la séquence de bits préalablement soumise à un codage source et exempte d'erreurs.

14. Procédé selon l'une quelconque des revendications 1 à 13,
utilisé dans le cadre d'une vidéoconférence

15. Dispositif de décodage canal dans un flux de données comprenant des données utiles et des données redondantes, le flux de données présentant au moins une séquence de bits préalablement soumise à un codage source et contenant des erreurs, la séquence de bits préalablement soumise à un codage source et exempte d'erreurs étant une séquence de bits connue, avec
- un décodeur de canal destiné à un décodage canal réitéré dans le flux de données,
- un organe de détection destiné à déterminer une séquence de bits préalablement soumise à un codage source et contenant des erreurs à partir du flux de données, une information d'erreur concernant la séquence de bits préalablement soumise à un codage source et contenant des erreurs pouvant être déterminée lors de la détermination de la séquence de bits préalablement soumise à un codage source et contenant des erreurs,
- l'organe de détection étant relié au détecteur de canal de manière à ce que l'information d'erreurs concernant la séquence de bits préalablement soumise à un codage source et contenant des erreurs puisse être amenée au décodeur de canal et à ce que ce dernier prenne en considération l'information d'erreurs lors du décodage canal réitéré dans le flux de données.

16. Dispositif selon la revendication 15,
avec un décodeur de source, lequel est muni de l'organe de détection.

17. Support informatique lisible par ordinateur, dans lequel est mémorisé un programme informatique pour le décodage canal dans un flux de données comprenant des données utiles et des données redondantes, le flux de données présentant au moins une séquence de bits préalablement soumise à un codage source et contenant des erreurs, la séquence de bits correspondante préalablement soumise à un codage source et exempte d'erreurs étant une séquence de bits connue, qui lorsqu'il est exécuté par un processeur présente les étapes de procédé suivantes :
- le flux de données est soumis à un décodage canal,
- la séquence de bits préalablement soumise à un codage source et contenant des erreurs est déterminée à partir du flux de données ayant subi un décodage canal, une information d'erreurs concernant la séquence de bits préalablement soumise à un codage source et contenant des erreurs étant déterminée,
- le flux de données est soumis à un décodage canal réitéré, le décodage canal réitéré dans le flux de données étant effectué sous considération de l'information d'erreurs.

18. Elément d'un programme informatique pour le décodage canal dans un flux de données comprenant des données utiles et des données redondantes, le flux de données présentant au moins une séquence de bits préalablement soumise à un codage source et contenant des erreurs, la séquence de bits correspondante préalablement soumise à un codage source et exempte d'erreurs étant une séquence de bits connue, qui lorsqu'il est exécuté par un processeur présente les étapes de procédé suivantes :
- le flux de données est soumis à un décodage canal,
- la séquence de bits préalablement soumise à un codage source et contenant des erreurs est déterminée à partir du flux de données ayant subi un décodage canal, une information d'erreurs concernant la séquence de bits préalablement soumise à un codage source et contenant des erreurs étant déterminée,
- le flux de données est soumis à un décodage canal réitéré, le décodage canal réitéré dans le flux de données étant effectué sous considération de l'information d'erreurs.
